# EUROPEAN PATENT APPLICATION

(11) **EP 1 739 739 A1**
(43) Date of publication of application: **03.01.2007**
(21) Application number: 04792048.3
(22) Date of filing: 05.10.2004
(51) Int. Cl.: H01L 23/12, H01L 21/60

(54) **THROUGH WIRING BOARD AND METHOD FOR PRODUCING THE SAME**

(30) Priority: 26.03.2004 JP 2004092667
(71) Applicant: FUJIKURA LTD., Kohtoh-ku, Tokyo 135-8512 (JP)
(72) Inventor: WADA, Hideyuki c/o Fujikura Ltd, Tokyo 135-8512 (JP); SUEMASU, Tatsuo Fujikura Ltd., Tokyo 135-8512 (JP)
(74) Representative: Grünecker, Kinkeldey, Stockmair & Schwanhäusser Anwaltssozietät
(86) International application number: PCT/JP2004/014637
(87) International publication number: WO 2005/093827

(57) **Abstract**

A through wiring board provided with through wiring extending through the through hole of the board. The through wiring board comprises a through hole made through the board, through extension wiring provided in the through hole and extending on one side of the through wiring board up to a position at a predetermined distance from the through hole, and a conductive bump formed on the through extension wiring except the through hole position.

## Description

### Field of The Invention

The present invention relates to a through wiring board and a method of manufacturing the same in which a through wiring (a through electrode) is used as a connecting element between the opposite surfaces of the board, and more specifically relates to a through wiring board and a method of manufacturing the same in which the durability of the through wiring board and devices to be mounted is improved by the structure of the through wiring for connecting between the opposite sides of the silicon board.

### Background Art

In the prior art technique, a through wiring board is used, for example, in order that a circuit or the like is implemented by directly utilizing a through wiring (a through electrode) serving as a connecting element between the opposite surfaces of the board, or that a circuit or the like is implemented by providing a bump just below the through wiring for forming a connecting element between boards.

In what follows, a variety of examples of a prior art through wiring board will be explained with reference to a view (cross sectional side view).

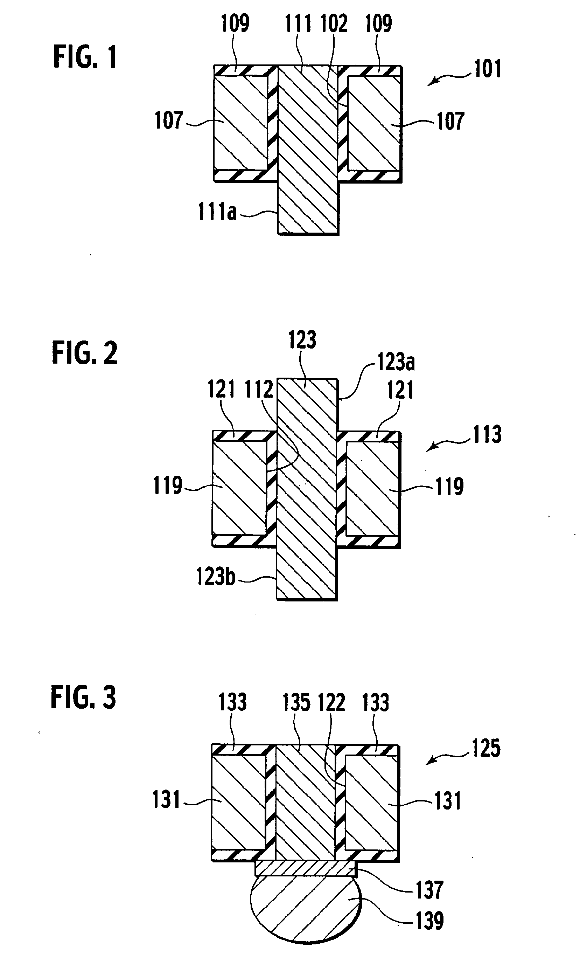

For example, as illustrated in Fig. 1, a board member 107 of a through wiring board 101 is provided with a through hole 102 formed therethrough and an insulating layer 109 formed on the surfaces of this board member 107 and on the side wall of the through hole 102. Then, a through wiring 111 is formed through the through hole 102 with the lower end 111a of the through wiring 111 projected from the wiring surface which is a lower surface of the through wiring board 101. By this configuration of the through wiring board 101, it is possible to perform the connection with another board through the lower end 111a of the through wiring 111.

In addition to this, as shown in Fig. 2, a board member 119 of a through wiring board 113 is provided with a through hole 112 formed therethrough and an insulating layer 121 formed on the surfaces of this board member 119 and on the side wall of the through hole 112, and a through wiring 123 is formed through the through hole 112 with the upper end 123a and lower end 123b of the through wiring 123 projected from the opposite wiring surfaces of the through wiring board 113. By this configuration of the through wiring board 113, it is possible to perform the connection with other boards through the upper end 123a and lower end 123b of the through wiring 111.

Furthermore, as shown in Fig. 3, a board member 131 of a through wiring board 125 is provided with a through hole 122 formed therethrough and an insulating layer 133 formed on the surfaces of this board member 131 and on the side wall of the through hole 122, and a through wiring 135 is formed through the through hole 122 with a pad 137 is formed on the exposed location of the through wiring 135 inserted into the through hole 122. In addition to this, a bump 139 is formed on the pad 137, through which another board is connected.

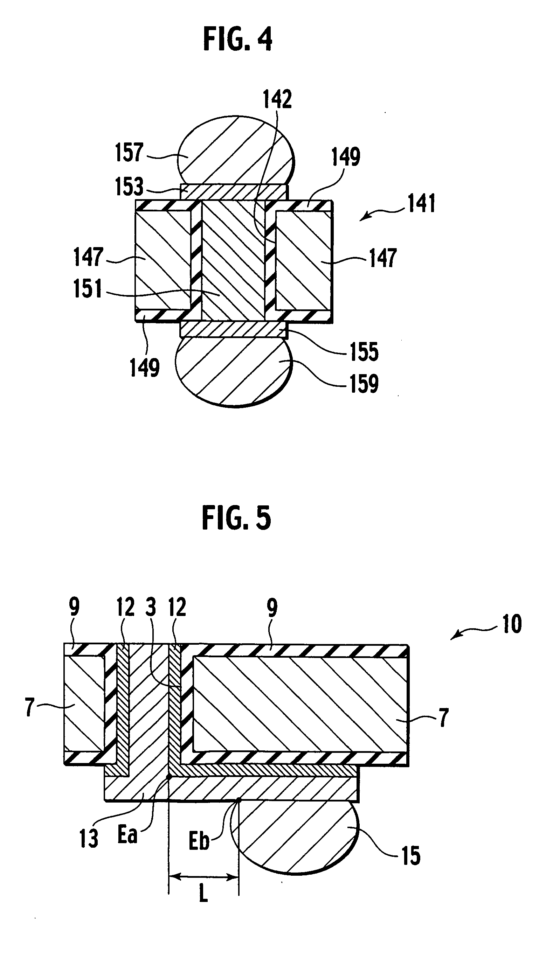

Still further, as shown in Fig. 4, a board member 147 of a through wiring board 141 is provided with a through hole 142 formed therethrough and an insulating layer 149 formed on the surfaces of this board member 147 and on the side wall of the through hole 142, and a through wiring 151 is formed through the through hole 142 with a pad 153 and a pad 155 are formed on the exposed location of each of the opposite surfaces of the through wiring 151 inserted into the through hole 142. Then, a bump 157 and a bump 159 are formed respectively on the pad 153 and the pad 155, through which other boards are connected.

In accordance with the technique as described above, it is known to provide a through electrode 5b which is protruded from the lower surface of a semiconductor wafer substrate 1, for example, as described in Japanese Patent Published Application No. 2001-351997.

In the case of such a conventional through wiring board, there is a problem as described below.

That is, when the through wiring board is mounted on another board, a pressure and a heat are applied thereto. Because of this, in the case where the through wiring is used as a connecting element as it is for connecting with another board, since a stress (for example, a pressure from this another board) is applied to the through wiring during implementation, there is a problem that the through wiring tends to easily be damaged. Furthermore, while a device and the like can be mounted on the through wiring board, in such a case, there is a problem that, depending upon the device, it can warp to change the device characteristics because of the stress applied to the through wiring board during implementation.

On the other hand, in the case where the through wiring is used as a connecting element as it is for connecting with another board, if a low melting metal is used to form the through wiring, the through wiring may be exposed to a high temperature during implementation so that the metal of the through wiring is melt, and a stress is applied between the through wiring board and the through wiring. Because of this, there is a problem that the through wiring is moved or comes off so that it cannot serve as the through wiring board.

Furthermore, in the case of the implementation by the use of a bump formed just below (or above) the through wiring, while a stress is applied to the through wiring during implementation, a pad is provided so that the stress is concentrated at the connection area between the pad and the through wiring board, and there is a problem that the stress concentration area tends to easily be damaged.

In addition to this, when the bump is formed, the through wiring board is exposed to a high temperature (~ 400 °C). In this case, if the melting point of the metal used to form the through wiring is less than or equal to 400 °C, there is a problem that, since the through wiring is melted and expanded, a stress is generated at the connection area between the pad and the through wiring board, and that the connection area is broken.

Furthermore, in the case where a bump is formed just below (or above) the through wiring as described above, unless an appropriate barrier metal (Ni, Pt, TiW or TiN is mainly used, but a Ta compound, a W compound, a Si compound or the like can be used for this purpose) is used to separate the through wiring and the bump, the metal of the through wiring is mixed with the metal of the bump, and thereby there is a problem that, even in the case where there is no damage in the appearance, the electric characteristics peculiar to the material (metal) cannot be obtained to deteriorate the intended functionality of the through wiring (that is, the characteristics of the through wiring board itself change).

The present invention has been made in order to solve the shortcomings as described above. It is an object of the present invention to provide a through wiring board and a manufacturing method thereof in which even in the case where a pressure and a heat are applied to the through wiring board when it is mounted on another board, the durability of the through wiring board and devices to be mounted is improved.

### Summary of The Invention

In order to accomplish the object as described above, the present invention is characterized in that a through wiring board is provided with a through wiring in a through hole which is formed through a board, said through wiring board comprising: the through hole opened through said board; a through extension wiring with which said through hole is filled and which is formed on one surface of said through wiring board to extend to a position at a predetermined distance from said through hole; and a bump having a conductivity, formed on said through extension wiring and located in a position other than the position where said through hole is opened.

Also, the present invention is characterized in that an insulating layer is provided between said board and at least said through wiring and said through extension wiring.

Furthermore, the present invention is characterized in that said through wiring board further comprises: a through extension wiring with which said through hole is filled in the other surface of said through wiring board and which is formed on the other surface of said through wiring board to extend to a position at a predetermined distance from said through hole; and a bump having a conductivity, formed on said through extension wiring and located in a position other than the position where said through hole is opened.

Still further, the present invention is characterized in that a through wiring board is provided with a through wiring in a through hole which is formed through a board, said through wiring board comprising the through hole opened through said board; an insulating resin layer formed on the surface of said through wiring board except for the area where said through hole is opened in at least one surface of said through wiring board; a through extension wiring with which said through hole is filled and which is formed on said insulating resin layer on said one surface of said through wiring board to extend to a position at a predetermined distance from said through hole; and a bump having a conductivity, formed on said through extension wiring and located in a position other than the position where said through hole is opened.

Still further, the present invention is characterized by a method of manufacturing a through wiring board provided with a through wiring in a through hole which is formed through a board, comprising: a step of forming the through hole opened through said board; a step of forming a through extension wiring on one surface of said through wiring board to fill said through hole and extend to a position at a predetermined distance from said through hole, and a step of forming a bump having a conductivity on said through extension wiring in a position other than the position where said through hole is opened.

Still further, the present invention is characterized by a method of manufacturing a through wiring board provided with a through wiring in a through hole which is formed through a board, said method comprising a step of forming the through hole opened through said board; a step of forming an insulating resin layer on the surface of said through wiring board except for the area where said through hole is opened in at least one surface of said through wiring board; a step of forming a through extension wiring on one surface of said insulating resin layer to fill said through hole and extend to a position at a predetermined distance from said through hole; and a step of forming a bump having a conductivity on said through extension wiring in a position other than the position where said through hole is opened.

Still further, the present invention is characterized by a through wiring board provided with a through wiring in a through hole which is formed through a board, said through wiring board comprising: the through hole opened through said board; a through wiring formed in said through hole; a reroute wiring which comes in contact with an exposed wiring portion of said through wiring and which is formed in at least one surface of said through wiring board to extend on said one surface of said through wiring board to a position at a predetermined distance from said exposed wiring portion; and a bump having a conductivity, formed on said reroute wiring and located in a position other than the position where said reroute wiring of said through wiring is formed.

Still further, the present invention is characterized in that an insulating layer is provided between said board and at least said through wiring and said reroute wiring.

Still further, the present invention is characterized in that the through wiring board further comprises: a reroute wiring which comes in contact with an exposed wiring portion of said through wiring in the other surface of said through wiring board and which is formed on the other surface of said through wiring board to extend to a position at a predetermined distance from said exposed wiring portion; and a bump having a conductivity, formed on said reroute wiring and located in a position other than the position where said exposed wiring portion of said through wiring is formed.

Still further, the present invention is characterized by a through wiring board provided with a through wiring in a through hole which is formed through a board, said through wiring board comprising: the through hole opened through said board; and a through wiring formed in said through hole; an insulating resin layer formed on the surface of said through wiring board except for the area where said exposed wiring portion is located in at least one surface of said through wiring board; a reroute wiring which comes in contact with an exposed wiring portion of said through wiring and which is formed on said insulating resin layer in at least one surface of said through wiring board to extend to a position at a predetermined distance from said exposed wiring portion; and a bump having a conductivity, formed on said reroute wiring and located in a position other than the position where said exposed wiring portion is formed.

Still further, the present invention is characterized in that there is a protrusion made of an insulating resin on said insulating resin layer formed on the surface of said through wiring board except for the area where said exposed wiring portion is located, wherein said reroute wiring is formed in order to cover said protrusion, and wherein the bump having the conductivity is formed on said reroute wiring which is formed on the upper surface of said protrusion.

Still further, the present invention is characterized by a method of manufacturing a through wiring board provided with a through wiring in a through hole which is formed through a board, said method comprising a step of forming a through wiring in the through hole opened through said board; a step of forming a reroute wiring in at least one surface of said through wiring board in order to come in contact with an exposed wiring portion of said through wiring and extend to a position at a predetermined distance from said exposed wiring portion; and a step of forming a bump having a conductivity on said through extension wiring in a position other than the position where said through hole is opened.

Still further, the present invention is characterized by a method of manufacturing a through wiring board provided with a through wiring in a through hole which is formed through a board, said method comprising a step of forming a through wiring in the through hole opened through said board; a step of forming an insulating resin layer on the surface of said through wiring board except for the area where said exposed wiring portion is located in at least one surface of said through wiring board; a step of forming a reroute wiring in at least one surface of said through wiring board in order to come in contact with an exposed wiring portion of said through wiring and extend on said insulating resin layer to a position at a predetermined distance from said exposed wiring portion; and a step of forming a bump having a conductivity on said through extension wiring in a position other than the position where said through hole is opened.

### Brief Description Of The Drawings

[Fig. 1] Fig. 1 is a cross sectional side view for showing a prior art through wiring board.
[Fig. 2] Fig. 2 is a cross sectional side view for showing a prior art through wiring board.
[Fig. 3] Fig. 3 is a cross sectional side view for showing a prior art through wiring board.
[Fig. 4] Fig. 4 is a cross sectional side view for showing a prior art through wiring board.
[Fig. 5] Fig. 5 is a cross sectional side view for showing the through wiring board in accordance with the present invention as a first embodiment.
[Fig. 6] Fig. 6 is a manufacturing process chart of the through wiring board as shown in Fig. 5.
[Fig. 7] Fig. 7 is a cross sectional side view for showing the through wiring board in accordance with the present invention as a second embodiment.
[Fig. 8] Fig. 8 is a manufacturing process chart of the through wiring board as shown in Fig. 7.
[Fig. 9] Fig. 9 is a cross sectional side view for showing the through wiring board in accordance with the present invention as a third embodiment.
[Fig. 10] Fig. 10 is a cross sectional side view for showing the through wiring board in accordance with the present invention as a fourth embodiment.
[Fig. 11] Fig. 11 is a cross sectional side view for showing an exemplary modification of the through wiring board in accordance with the present invention.
[Fig. 12] Fig. 12 is a cross sectional side view for showing an exemplary modification of the through wiring board in accordance with the present invention.
[Fig. 13] Fig. 13 is a cross sectional side view for showing an exemplary modification of the through wiring board in accordance with the present invention.
[Fig. 14] Fig. 14 is a cross sectional side view for showing an exemplary modification of the through wiring board in accordance with the present invention.

### Best Mode for Carrying Out the Invention

In what follows, the embodiment of the present invention will be explained with reference to the accompanying drawings.

First, it is assumed that the through wiring board used in this example is a silicon substrate (a silicon IC chip or the like), which is mounted on another board. And, for example, a bump is used to connect with a bump in place of wire bonding. Incidentally, as has been discussed above, when the through wiring board is mounted on another board, a pressure and a heat are applied thereto.

A through wiring board in accordance with the present invention as a first embodiment will be explained with reference to Fig. 5. Fig. 5 is a cross sectional side view for showing the through wiring board in accordance with the present invention as the first embodiment.

As shown in Fig. 5, this through wiring board 10 is provided with a board member 7 made of silicon or the like, an insulating layer 9 such as an oxide film formed on the opposite surfaces of the board member 7 and the inner peripheral surface of a microscopic through hole 3 formed through the board member 7, a through extension wiring 13 with which the through hole 3 is filled and which is formed extending over the insulating layer 9 on the bottom surface of the board member 7 in order to reach a position at a predetermined distance from the through hole 3, and a bump 15 such as a solder located on the through extension wiring 13 at a position apart from the through hole 3 for the purpose of connecting with another board.

Meanwhile, a seed layer 12 is provided between the insulating layer 9 and the through extension wiring 13 for the purpose of improving the adhesiveness of the through extension wiring 13.

This bump can be formed for example by printing, and for example it serves to make wiring connection between the through wiring board and another board by superimposing the respective boards on each other.

In this case, the through extension wiring 13 is formed of a material which is preferably Cu but may be an Au-Sn eutectic alloy (80 wt. % of Au-20 wt. % of Sn, 10 wt. % of Au - 90 wt. % of Sn). Incidentally, an SnPb or Pb base solder material or a solder material having an Au or Al component can be used, but it is preferred that the material can be formed by plating a metal or the like.

Also, the thicknesses of the respective elements are selected such that the board member 7 has a thickness of the order of 200 to 600 µm, the insulating layer 9 such as an oxide film has a thickness of the order of 0.5 to 1 µm, and the through extension wiring 13 on the bottom surface of the board member 7 has a thickness of the order of 1 to 5*µ*m.

Next, the predetermined distance of the through extension wiring 13 from the through hole 3 to the bump 15 will be explained in detail.

Namely, as shown in Fig. 5, in the case where the structure is implemented only one side of the through wiring board 10, if it is assumed that "L" is the shortest distance between the outer circumference Ea of the through extension wiring 13 and the outer circumference Eb of the contact area between the bump 15 and the through extension wiring 13, the shortest distance "L" falls within a range in which L ≧ O. That is to say, even if the distance L = 0, the bump 15 shall not be located just below the through extension wiring 13 in the through hole 3 because the opposite ends (Ea, Eb) of the distance "L" are defined at their outer circumferences. By this configuration, the through extension wiring 13 and the like in the through hole 3 is protected against the pressure applied from the bump 15. Incidentally, the maximum of the distance "L" may be determined anywhere in the through wiring board.

The outer circumference Ea of the through extension wiring 13 in the through hole 3 is an outer perimeter in the case where the through hole 3 is a circle, but is a side or a vertex in the case where the through hole 3 is an n-sided polygon (n ≧ 3). Also in the case of any other profile, the outer circumference Ea is a circle's perimeter, a side or a vertex of the profile.

As has been discussed above, since the bump is located in a position at a predetermined distance from the through wiring, when mounting later, the connection with another element can be made by the bump at a position apart from the through wiring rather than by means of the through wiring itself or a bump which is located just below or above the through wiring, and thereby there is an advantage that the stress during implementation is not applied to the through wiring.

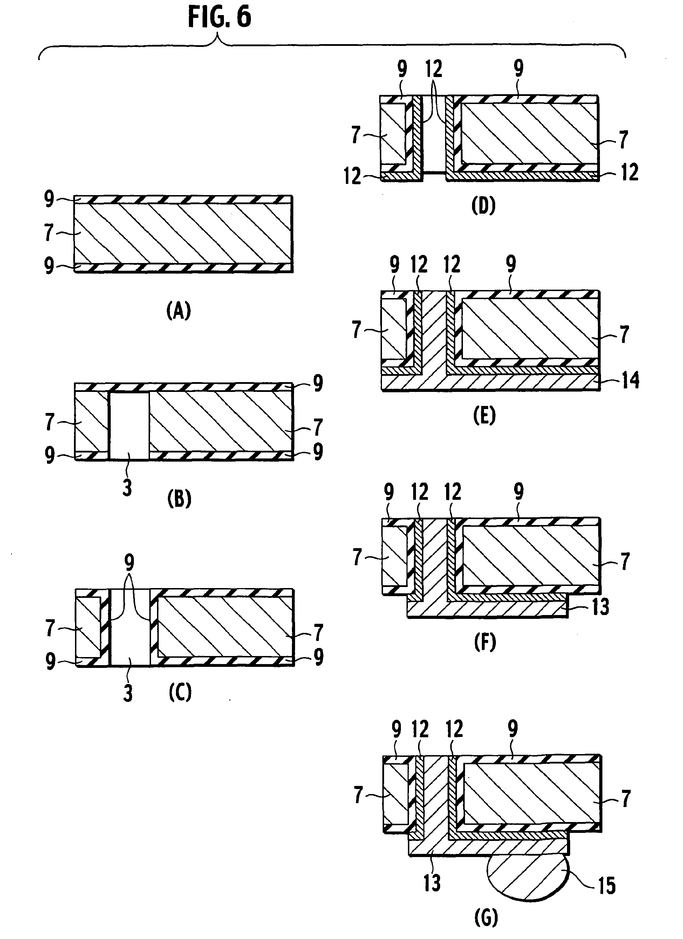

Next, with reference to Fig. 6, the method of manufacturing the through wiring board 10 as shown in Fig. 5 will be explained. Fig. 6 is a manufacturing process chart of the through wiring board 10 as shown in Fig. 5.

First, the board member 7, which is made for example of silicon and has a thickness of the order of 200 to 600 µm, is prepared, and the insulating layer 9 such as an oxide film is formed on the opposite surfaces of the board member 7 to a thickness of the order of 0.5 to 1 µm (refer to Fig. 6A). Next, a microscopic hole of the order of 50 to 100 µm Φ is formed from the bottom surface of the board member 7 in order to form an opening through the insulating layer 9 in the bottom side of the board member 7 and perform silicon etching, so that the through hole 3 is formed for use in forming a through wiring 11 (refer to Fig. 6B).

Next, the insulating layer 9 such as an oxide film is formed on the inner peripheral surface of the through hole 3 to a thickness of the order of 0.5 to 1 µm (refer to Fig. 6C), and an opening is formed through the insulating layer 9 in the upper side of the board member 7 in the through hole 3. Next, a barrier metal seed layer 12 is formed by CVD of Cu/TiN on the insulating layer 9 to cover the inner peripheral surface of the through hole 3 and the insulating layer 9 in the lower side of the board member 7. With this barrier metal seed layer 12, the adhesiveness between the insulating layer 9 and the through extension wiring 13 to be formed later is improved (refer to Fig. 6D).

Next, filling of a metal such as Cu is performed over the barrier metal seed layer 12 by plating and so forth (refer to Fig. 6E), and the through extension wiring 13 is formed by photolithography and etching to perform patterning (refer to Fig. 6F). Incidentally, the thickness of the through extension wiring 13 in the lower side of the board member 7 is of the order of 1 to 5 *µ*m.

Then, the bump 15 is formed on the through extension wiring 13 in the predetermined position as has been described above (such that the shortest distance of Fig. 5 is "L") (refer to Fig. 6G). The bump 15 is formed by performing a reflow process after printing a paste such as solder, and the bump 15 is made of a material which is preferably a Pb free solder of an Sn - Ag - Cu (tin - silver - copper) base. Alternatively, it is preferred to use an Au-Sn eutectic alloy, an Sn-Pb or Pb base solder material or a solder material having an Au or Al component.

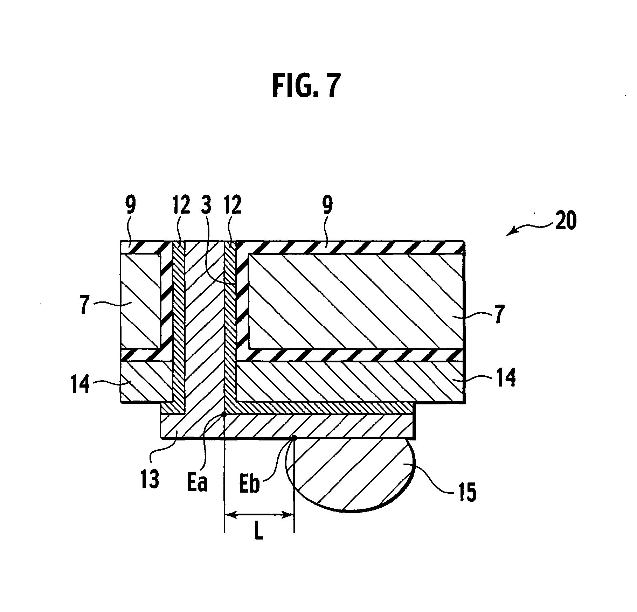

Next, with reference to Fig. 7, a through wiring board in accordance with the present invention as a second embodiment will be explained. Fig. 7 is a cross sectional side view for showing the through wiring board in accordance with the present invention as the second embodiment.

As shown in Fig. 7, this through wiring board 20 is provided with a board member 7 made of silicon or the like, an insulating layer 9 such as an oxide film formed on the opposite surfaces of the board member 7 and the inner peripheral surface of a microscopic through hole 3 formed through the board member 7, a resin layer 14 such as polyimide layer formed on the bottom surface of the board member 7 through the insulating layer 9, a through extension wiring 13 with which the through hole 3 is filled and which is formed extending over the resin layer 14 in the bottom side of the board member 7 in order to reach a position at a predetermined distance from the through hole 3, and a bump 15 such as a solder located on the through extension wiring 13 at a position apart from the through hole 3 for the purpose of connecting with another board.

Meanwhile, a barrier metal seed layer 12 is provided between the insulating layer 9 and the through extension wiring 13 for the purpose of improving the adhesiveness of the through extension wiring 13.

This bump 15 can be formed for example by printing, and for example it serves to make wiring connection between the through wiring board and another board by superimposing the respective boards on each other.

In this case, the through extension wiring 13 is formed of a material which is preferably Cu but may be an Au-Sn eutectic alloy (80 wt. % of Au-20 wt. % of Sn, 10 wt. % of Au - 90 wt. % of Sn). Incidentally, an SnPb or Pb base solder material or a solder material having an Au or Al component can be used, but it is preferred that the material can be formed by plating a metal or the like.

Also, the thicknesses of the respective elements are selected such that the board member 7 has a thickness of the order of 200 to 600 *µ*m, the insulating layer 9 such as an oxide film has a thickness of the order of 0.5 to 1 *µ*m, the resin layer 14 on the bottom surface of the board member 7 has a thickness of the order of 10 µm. and the through extension wiring 13 on the bottom surface of the board member 7 has a thickness of the order of 1 to 5 *µ*m.

Next, the predetermined distance of the through extension wiring 13 from the through hole 3 to the bump 15 will be explained in detail.

Namely, as shown in Fig. 7, in the case where the structure is implemented only in one side of the through wiring board 1, if it is assumed that "L" is the shortest distance between the outer circumference Ea of the through wiring 11 and the outer circumference Eb of the contact area between the bump 15 and the through extension wiring 13, the shortest distance "L" falls within a range in which L ≧ O. That is to say, even if the distance L = 0, the bump 15 shall not be located just below the through extension wiring 13 in the through hole 3 because the opposite ends (Ea, Eb) of the distance "L" are defined at their outer circumferences. By this configuration, the through extension wiring 13 and the like in the through hole 3 is protected against the pressure applied from the bump 15: Incidentally, the maximum of the distance "L" may be determined anywhere in the through wiring board.

The outer circumference Ea of the through extension wiring 13 in the through hole 3 is an outer perimeter in the case where the through hole 3 is a circle, but is a side or a vertex in the case where the through hole 3 is an n-sided polygon (n ≧ 3). Also in the case of any other profile, the outer circumference Ea is a circle's perimeter, a side or a vertex of the profile.

As has been discussed above, since the bump is located in a position at a predetermined distance from the through wiring, when mounting later, the connection with another element can be made by the bump at a position apart from the through wiring rather than by means of the through wiring itself or a bump which is located just below or above the through wiring, and thereby there is an advantage that the stress during implementation is not applied to the through wiring. And, in addition to this, since there is the resin layer 14 made of polyimide or the like between the through extension wiring 13 and the insulating layer 9 in the bottom side of the board member 7, it is possible to lessen the stress applied during implementation and improve the insulation property.

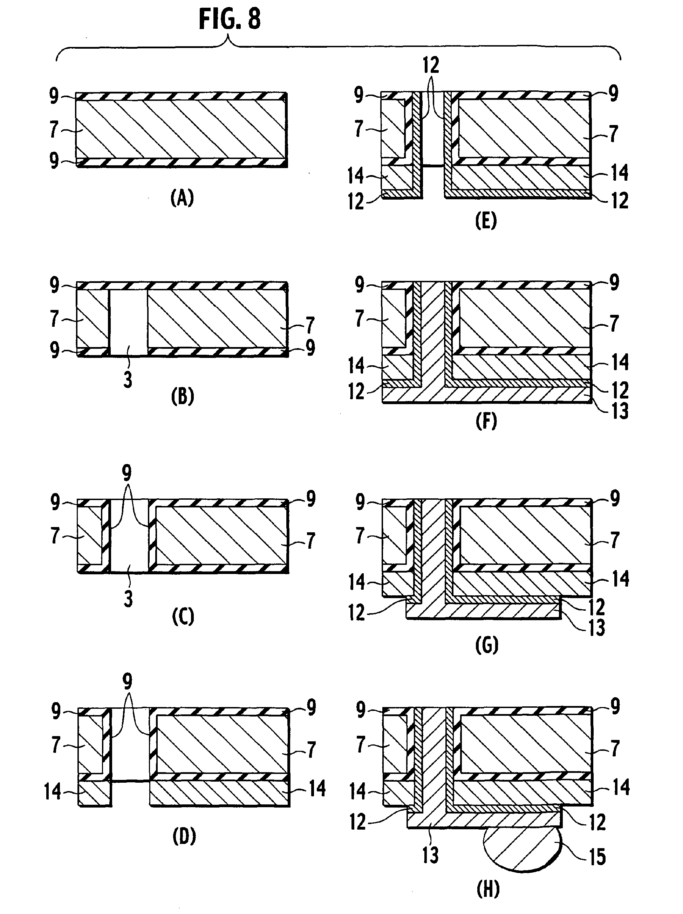

Next, with reference to Fig. 8, the method of manufacturing the through wiring board as shown in Fig. 7 will be explained. Fig. 8 is a manufacturing process chart of the through wiring board as shown in Fig. 7.

First, the board member 7, which is made for example of silicon and has a thickness of the order of 200 to 600 µm, is prepared, and the insulating layer 9 such as an oxide film is formed on the opposite surfaces of the board member 7 to a thickness of the order of 0.5 to 1 *µ*m (refer to Fig. 8A). Next, a microscopic hole of the order of 50 to 100 *µ*m Φ is formed from the bottom surface of the board member 7 in order to form an opening through the insulating layer 9 in the bottom side of the board member 7 and perform silicon etching, so that the through hole 3 is formed for use in forming a through wiring 11 (refer to Fig. 8B).

Next, the insulating layer 9 such as an oxide film is formed on the inner peripheral surface of the through hole 3 to a thickness of the order of 0.5 to 1 µm (refer to Fig. 8C), and an opening is formed through the insulating layer 9 in the upper side of the board member 7 in the through hole 3. Next, the resin layer 14 made of polyimide or the like is formed on the insulating layer 9 in the bottom side of the board member 7 (refer to Fig. 8D), and a barrier metal seed 12 is formed by CVD of Cu/TiN on the insulating layer 9 to cover the inner peripheral surface of the through hole 3 and the resin layer 14 in the lower side of the board member 7 (refer to Fig. 8E). With this barrier metal seed 12, the adhesiveness between the insulating layer 9 and the through extension wiring 13 to be formed later is improved.

Next, a metal such as Cu is used to coat the barrier metal seed 12 and fill the through hole 3 by plating and so forth (refer to Fig. 8F), and the through extension wiring 13 is formed by photolithography and etching to perform patterning (refer to Fig. 8G). Incidentally, the thickness of the through extension wiring 13 in the lower side of the board member 7 is of the order of 1 to 5 *µ* m.

Then, the bump 15 is formed on the through extension wiring 13 in the predetermined position as has been described above (such that the shortest distance is "L") (refer to Fig. 8H). The bump 15 is formed by performing a reflow process after printing a paste such as solder, and the bump 15 is made of a material which is preferably a Pb free solder of an Sn-Ag - Cu (tin - silver - copper) base. Alternatively, it is preferred to use an Au-Sn eutectic alloy, an Sn-Pb or Pb base solder material or a solder material having an Au or Al component.

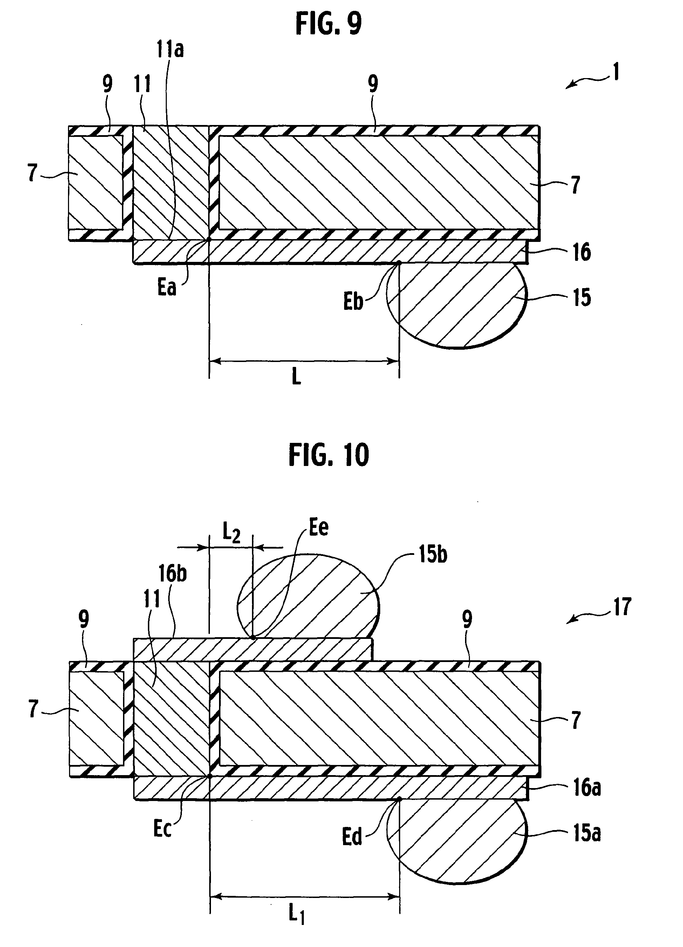

Next, with reference to Fig. 9, a through wiring board in accordance with the present invention as a third embodiment will be explained. Fig. 9 is a cross sectional side view for showing the through wiring board in accordance with the present invention as the third embodiment.

As shown in Fig. 9, this through wiring board 1 is provided with a board member 7 made of silicon or the like, an insulating layer 9 such as an oxide film formed on the opposite surfaces of the board member 7 and the inner peripheral surface of a microscopic through hole 3 formed through the board member 7, a through wiring 11 with which the through hole 3 is filled, a reroute wiring 16 which is brought in contact with the bottom surface 11a (the exposed portion of wiring) of the through wiring 11 and formed extending over the insulating layer 9 on the bottom surface of the board member 7 in order to reach a position at a predetermined distance from the through hole 3, and a bump 15 such as a solder located on the reroute wiring 16 at a position apart from the through hole 3 for the purpose of connecting with another board.

This bump 15 can be formed for example by printing, and for example it serves to make wiring connection between the through wiring board and another board by superimposing the respective boards on each other.

In this case, the reroute wiring 16 is formed of a material which is preferably Cu but may be an Au-Sn eutectic alloy (80 wt. % of Au - 20 wt. % of Sn, 10 wt. % of Au - 90 wt. % of Sn). Incidentally, an SnPb or Pb base solder material or a solder material having an Au or Al component can be used, but it is preferred that the material can be formed by plating a metal or the like.

Also, the thicknesses of the respective elements are selected such that the board member 7 has a thickness of the order of 200 to 600 µm, the insulating layer 9 such as an oxide film has a thickness of the order of 0.5 to 1 µm, and the reroute wiring 16 on the bottom surface of the board member 7 has a thickness of the order of 1 to 5 µm.

Next, the predetermined distance of the reroute wiring 16 from the through hole 3 to the bump 15 will be explained in detail.

Namely, as shown in Fig. 9, in the case where the structure is implemented only one side of the through wiring board 1, if it is assumed that "L" is the shortest distance between the outer circumference Ea of the through wiring 11 and the outer circumference Eb of the contact area between the bump 15 and the reroute wiring 16, the shortest distance "L" falls within a range in which L ≧ O. That is to say, even if the distance L = 0, the bump 15 shall not be located just below the through wiring 11 because the opposite ends (Ea, Eb) of the distance "L" are defined at their outer circumferences. By this configuration, the through wiring 11 and the like is protected against the pressure applied from the bump 15. Incidentally, the maximum of the distance "L" may be determined anywhere in the through wiring board.

The outer circumference Ea of the through wiring 11 is an outer perimeter in the case where the through hole 3 is a circle, but is a side or a vertex in the case where the through hole 3 is an n-sided polygon (n ≧3). Also in the case of any other profile, the outer circumference Ea is a circle's perimeter, a side or a vertex of the profile.

As has been discussed above, since the bump is located in a position at a predetermined distance from the through wiring, when mounting later, the connection with another element can be made by the bump at a position apart from the through wiring rather than by means of the through wiring itself or a bump which is located just below or above the through wiring, and thereby there is an advantage that the stress during implementation is not applied to the through wiring.

Next, the method of manufacturing the through wiring board as shown in Fig. 9 will be explained.

The through hole 3, which is a microscopic hole of the order of 50 to 100 *µ*m Φ, is formed through the board member 7, which is made for example of silicon and has a thickness of the order of 200 to 600 *µ*m. This microscopic hole may be formed for example by RIE.

Thereafter, the insulating layer 9 such as an oxide film is formed on the opposite surfaces of the board member 7 and the inner surface of the through hole 3. This insulating layer 9 has a thickness of the order of 0.5 to 1 µm and serves as an insulating layer against the outside.

Thereafter, the through hole 3 of the through wiring board is filled with a metal in order to form the through wiring 11. The filling of this metal is performed by flowing molten metal into the through hole 3 under a reduced pressure.

Next, a metal film serving as the reroute wiring 16 is formed on the entire surface in the bottom side of the board member 7, and then patterned by a photolithography technique or the like in order that the predetermined reroute wiring 16 is formed by etching the metal film to leave necessary portions. And, this reroute wiring 16 is formed extending to the position (that is, the bump formation portion other than the exposed portion) at a predetermined distance from the exposed portion 11a of the through wiring 11. This reroute wiring 16 is made of a material such as Cu, Al.

Thereafter, the bump 15 is formed in the predetermined position as described above. The bump 15 is formed by performing a reflow process after printing a paste such as solder. The bump 15 is made of a material which is preferably a Pb free solder of an Sn-Ag-Cu (tin-silver-copper) base. Alternatively, it is preferred to use an Au -Sn eutectic alloy, an Sn-Pb or Pb base solder material or a solder material having an Au or Al component.

Next, with reference to Fig. 10, a through wiring board in accordance with the present invention as a fourth embodiment will be explained. Fig. 10 is a cross sectional side view for showing the through wiring board in accordance with the present invention as the fourth embodiment.

In the structure according to the fourth embodiment, as shown in Fig. 10, a second reroute wiring 16b is formed also on the upper surface of the through wiring board in accordance with the third embodiment of Fig. 9.

Namely, this through wiring board 17 is provided with a board member 7 made of silicon or the like, an insulating layer 9 such as an oxide film formed on the opposite surfaces of the board member 7 and the inner peripheral surface of a microscopic through hole 3 formed through the board member 7, a through wiring 11 with which the through hole 3 is filled, a reroute wiring 16a formed extending over the insulating layer 9 on the bottom surface of the board member 7 in order to reach a position at a predetermined distance from the bottom surface 11a of the through wiring 11, a bump 15a such as a solder located on the reroute wiring 16a at a position apart from the through hole 3 for the purpose of connecting with another board, a reroute wiring 16b formed extending over the insulating layer 9 on the upper surface of the board member 7 in order to reach a position at a predetermined distance from the upper surface 11b of the through wiring 11, and a bump 15b such as a solder located on the reroute wiring 16a at a position apart from the through hole 3 for the purpose of connecting with another board.

Next, the predetermined distance of the reroute wiring 16a or 16b from the through hole 3 to the bump 15a or 15b will be explained in detail.

Namely, in the case where the structure is implemented in the opposite sides of the through wiring board 1 as illustrated in Fig. 10, it is assumed that the distance L1 and distance L2 are, respectively, the shortest distances between the bumps 15a and 15b and the reroute wirings 16a and 16b exposed in the opposite sides of the through wiring board 17. One end of each of the distances L1 and L2 of the reroute wirings 16a and 16b is defined on the outer circumference Ec of the through wiring 11. The outer circumference Ec is an outer perimeter in the case of a circle. Alternatively, the outer circumference is a side or a vertex in the case of an n-sided polygon (n ≧ 3). Also in the case of any other profile, the outer circumference Ea is a circle's perimeter, a side or a vertex of the profile. On the other hand, the other end of the distance L1 of the reroute wirings 16a is defined on the outer circumference Ed of the contact area between the bump 15a and the reroute wirings 16a. Also, the other end of the distance L2 of the reroute wirings 16b is defined on the outer circumference Ee of the contact area between the bump 15b and the reroute wirings 16b.

In this case, the shortest distance L1 falls within a range in which L1 ≧ O, and the shortest distance L2 falls within a range in which L2 ≧ O. The maximum of the distance L1 or the distance L2 may be determined anywhere in the through wiring board, and depend on the size of the board as used.

Needless to say, the relationship between the distance L1 and the distance L2 is either the distance L1 = the distance L2 or the distance L1 # the distance L2. Even in the case where the distance L1 = the distance L2, since the bump 15 shall not be located just below the through wiring, no excessive stress is not applied to the through wiring 11.

As apparent from the explanation as described above, the connection is not made directly through the through wiring or by means of a bump formed just below (above) the through wiring, but is made by means of a bump formed apart from the position just below the through wiring, and thereby a stress in the vertical direction is not applied to the through wiring during implementation so that the through wiring is not damaged.

Next, the method of manufacturing the through wiring board as shown in Fig. 10 will be explained.

The through hole 3, which is a microscopic hole of the order of 50 to 100 *µ*m Φ, is formed through the board member 7, which is made for example of silicon and has a thickness of the order of 200 to 600 *µ*m. This through hole 3 may be formed for example by RIE.

Thereafter, the insulating layer 9 such as an oxide film is formed on the opposite surfaces of the board member 7 and the inner surface of the through hole 3. This insulating layer 9 has a thickness of the order of 0.5 to 1 *µ*m and serves as an insulating layer against the outside.

Thereafter, the through hole 3 of the through wiring board is filled with a metal in order to form the through wiring 11. The filling of this metal is performed by flowing molten metal into the through hole 3 under a reduced pressure.

Next, a metal film serving as the reroute wirings 16a and 16b is formed on the entire surfaces in the bottom side and the upper surface of the board member 7, and then patterned by a photolithography technique or the like in order that the predetermined reroute wirings 16a and 16b are formed by etching the metal film to leave necessary portions. And, this reroute wirings 16a and 16b are formed extending to the positions (that is, the bump formation portion other than the exposed portion) at predetermined distance from the exposed portions 11a and 11b of the through wiring 11. These reroute wirings 16 are made of a material such as Cu, Al.

Thereafter, the bumps 15a and 15b are formed in the predetermined positions as described above. The bumps 15a and 15b are formed by performing a reflow process after printing a paste such as solder. The bumps 15a and 15b are made of a material which is preferably a Pb free solder of an Sn-Ag-Cu (tin-silver-copper) base. Alternatively, it is preferred to use an Au-Sn eutectic alloy, an Sn-Pb or Pb base solder material or a solder material having an Au or Al component.

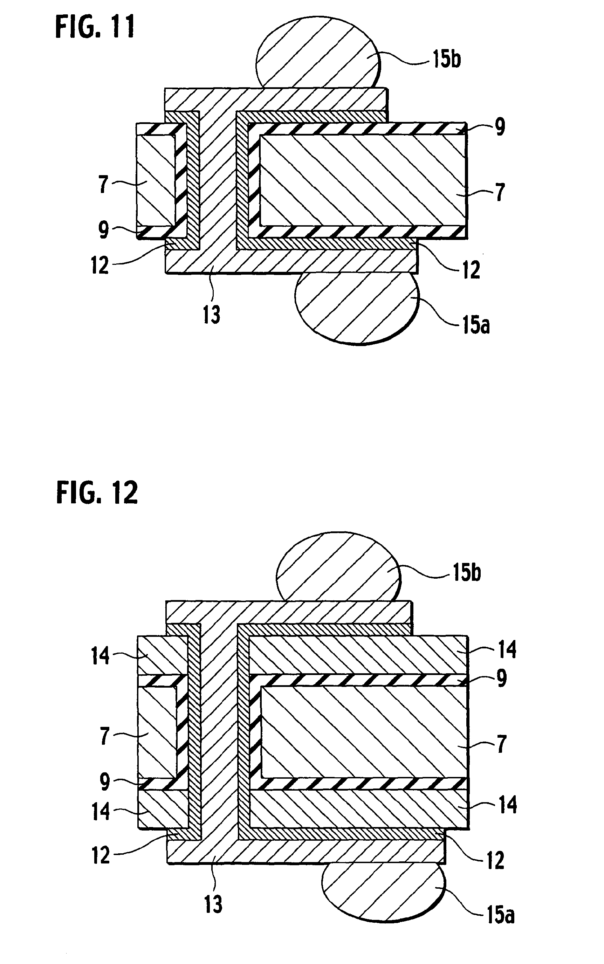

Meanwhile, in the structure according to the fourth embodiment illustrated in Fig. 10, wirings (the reroute wirings 16) are formed on the opposite surfaces of the through wiring board shown in Fig. 9. However, as shown in Fig. 11, it is possible to provide the through extension wiring 13 on each of the opposite surfaces of the through wiring board shown in Fig. 5 in accordance with the first embodiment. And, as shown in Fig. 12, it is also possible to provide the through extension wiring 13 on each of the opposite surfaces of the through wiring board shown in Fig. 7 in accordance with the second embodiment.

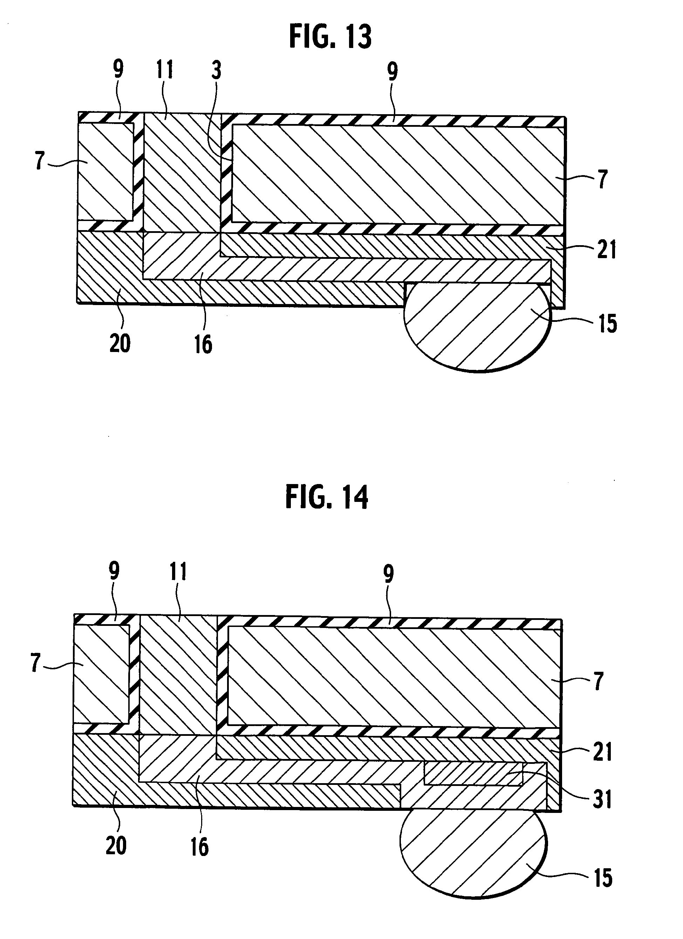

Next, exemplary modifications will be explained with reference to Fig. 13 and Fig. 14.

As shown in Fig. 13, in the case of this first exemplary modification, stress relaxation layers 20, 21 are formed in order to surround the reroute wiring 16 in accordance with the third embodiment shown in Fig. 9 in order to realize a structure in which the pressure applied to the reroute wirings 16 is lessened. By this structure, the stress applied to the reroute wirings 16 from the bump 15 and the like is absorbed by the stress relaxation layer 21.

As shown in Fig. 14, in accordance with this second exemplary modification, the reroute wiring 16 of the first exemplary modification shown in Fig. 13 is provided with a core post 31 which is protruded in the board side and located in the position corresponding to the bump 15 in order to realize a structure in which the stress applied from the outside (another board or the like) is lessened. By this structure, the core post 31 serves to absorb the stress applied to the reroute wirings 16 from the bump 15. Since the core post 31 is formed to protrude in the location corresponding to the bump 15, a larger stress can be absorbed (relaxed). Then, it is preferred that the gravity center of the core post 31 coincides with the gravity center of the bump 15. This enables appropriate stress relaxation.

Furthermore, it is preferred that the core post 31 is formed on the stress relaxation layer 21. By this configuration, there is an advantage that the stress is further relaxed by the double relaxation layers to protect the through wiring board.

Incidentally, the present invention is not limited to the embodiments as described above, but can be practiced as other embodiments with appropriate modifications.

### Industrial Applicability

In accordance with the present invention as has been discussed above, since a bump is provided in a position at a predetermined distance from the through wiring, when mounting later, the connection with another element can be made by the bump at a position apart from the through wiring rather than by means of the through wiring itself or a bump which is located just below or above the through wiring, and thereby there is an advantage that the stress during implementation is not applied to the through wiring.

In addition to this, while it is important to relax the stress applied to the through wiring board, in the case where a stress relaxation layer or a resin core post is provided, there is an advantage that it is possible to lessen the deformation due to the stress applied not only to the through wiring but also to the entirety of the through wiring board. Then, there are an advantage that it is possible to relax the thermal stress, the mechanical stress, shocks, the concentration of stress, deformation and so forth when using a device mounted on the through wiring board, such that the long term reliability can be improved.

On the other hand, since the through wiring and the bump are located in a spaced-apart relationship, diffusion of metal shall not occur between them at a high temperature, there is an advantage that the characteristics of material shall not change. Because of this, there is an advantage that it is possible to select an appropriate material for each element.

## Claims

1. A through wiring board provided with a through wiring in a through hole which is formed through a board, said through wiring board comprising: the through hole opened through said board; a through extension wiring with which said through hole is filled and which is formed on one surface of said through wiring board to extend to a position at a predetermined distance from said through hole; and a bump having a conductivity, formed on said through extension wiring and located in a position other than the position where said through hole is opened.

2. The through wiring board as claimed in claim 1 wherein an insulating layer is provided between said board and at least said through wiring and said through extension wiring.

3. The through wiring board as claimed in claim 1 further comprising: a through extension wiring with which said through hole is filled in the other surface of said through wiring board and which is formed on the other surface of said through wiring board to extend to a position at a predetermined distance from said through hole; and a bump having a conductivity, formed on said through extension wiring and located in a position other than the position where said through hole is opened.

4. A through wiring board provided with a through wiring in a through hole which is formed through a board, said through wiring board comprising the through hole opened through said board; an insulating resin layer formed on the surface of said through wiring board except for the area where said through hole is opened in at least one surface of said through wiring board; a through extension wiring with which said through hole is filled and which is formed on said insulating resin layer on said one surface of said through wiring board to extend to a position at a predetermined distance from said through hole; and a bump having a conductivity, formed on said through extension wiring and located in a position other than the position where said through hole is opened.

5. A method of manufacturing a through wiring board provided with a through wiring in a through hole which is formed through a board, said method comprising: a step of forming the through hole opened through said board; a step of forming a through extension wiring on one surface of said through wiring board to fill said through hole and extend to a position at a predetermined distance from said through hole, and a step of forming a bump having a conductivity on said through extension wiring in a position other than the position where said through hole is opened.

6. A method of manufacturing a through wiring board provided with a through wiring in a through hole which is formed through a board, said method comprising a step of forming the through hole opened through said board; a step of forming an insulating resin layer on the surface of said through wiring board except for the area where said through hole is opened in at least one surface of said through wiring board; a step of forming a through extension wiring on one surface of said insulating resin layer to fill said through hole and extend to a position at a predetermined distance from said through hole; and a step of forming a bump having a conductivity on said through extension wiring in a position other than the position where said through hole is opened.

7. A through wiring board provided with a through wiring in a through hole which is formed through a board, said through wiring board comprising: the through hole opened through said board; a through wiring formed in said through hole; a reroute wiring which comes in contact with an exposed wiring portion of said through wiring and which is formed in at least one surface of said through wiring board to extend on said one surface of said through wiring board to a position at a predetermined distance from said exposed wiring portion; and a bump having a conductivity, formed on said reroute wiring and located in a position other than the position where said reroute wiring of said through wiring is formed.

8. The through wiring board as claimed in claim 7 wherein an insulating layer is provided between said board and at least said through wiring and said reroute wiring.

9. The through wiring board as claimed in claim 7 further comprising: a reroute wiring which comes in contact with an exposed wiring portion of said through wiring in the other surface of said through wiring board and which is formed on the other surface of said through wiring board to extend to a position at a predetermined distance from said exposed wiring portion; and a bump having a conductivity, formed on said reroute wiring and located in a position other than the position where said exposed wiring portion of said through wiring is formed.

10. A through wiring board provided with a through wiring in a through hole which is formed through a board, said through wiring board comprising: the through hole opened through said board; and a through wiring formed in said through hole; an insulating resin layer formed on the surface of said through wiring board except for the area where said exposed wiring portion is located in at least one surface of said through wiring board; a reroute wiring which comes in contact with an exposed wiring portion of said through wiring and which is formed on said insulating resin layer in at least one surface of said through wiring board to extend to a position at a predetermined distance from said exposed wiring portion; and a bump having a conductivity, formed on said reroute wiring and located in a position other than the position where said exposed wiring portion is formed.

11. The through wiring board as claimed in claim 10 wherein there is a protrusion made of an insulating resin on said insulating resin layer formed on the surface of said through wiring board except for the area where said exposed wiring portion is located, wherein said reroute wiring is formed in order to cover said protrusion, and wherein the bump having the conductivity is formed on said reroute wiring which is formed on the upper surface of said protrusion.

12. A method of manufacturing a through wiring board provided with a through wiring in a through hole which is formed through a board, said method comprising a step of forming a through wiring in the through hole opened through said board; a step of forming a reroute wiring in at least one surface of said through wiring board in order to come in contact with an exposed wiring portion of said through wiring and extend to a position at a predetermined distance from said exposed wiring portion; and a step of forming a bump having a conductivity on said through extension wiring in a position other than the position where said through hole is opened.

13. A method of manufacturing a through wiring board provided with a through wiring in a through hole which is formed through a board, said method comprising a step of forming a through wiring in the through hole opened through said board; a step of forming an insulating resin layer on the surface of said through wiring board except for the area where said exposed wiring portion is located in at least one surface of said through wiring board; a step of forming a reroute wiring in at least one surface of said through wiring board in order to come in contact with an exposed wiring portion of said through wiring and extend on said insulating resin layer to a position at a predetermined distance from said exposed wiring portion; and a step of forming a bump having a conductivity on said through extension wiring in a position other than the position where said through hole is opened.
